Europäisches Patentamt

European Patent Office

Office européen des brevets

(19)

(11) EP 0 357 507 B1

(12) EUROPEAN PATENT SPECIFICATION

(45) Date of publication and mention
of the grant of the patent:
06.03.1996 Bulletin 1996/10

(51) Int Cl.6: H01B 12/00, H01L 39/24, C04B 35/00

(21) Application number: 89402365.4

(22) Date of filing: 30.08.1989

(54) **Superconducting article containing thallium**

Supraleitendes Erzeugnis enthaltend Thallium

Article supraconducteur contenant du thallium

(84) Designated Contracting States:
AT BE CH DE ES FR GB GR IT LI LU NL SE

(30) Priority: 31.08.1988 US 238919
08.02.1989 US 308149

(43) Date of publication of application:
07.03.1990 Bulletin 1990/10

(73) Proprietor: SUPERCONDUCTOR
TECHNOLOGIES INC.
Santa Barbara California 93111-2310 (US)

(72) Inventors:
• Olson, William L.
Buellton California 94327 (US)
• Eddy, Michael M.
Goleta California 93117 (US)
• James, Timothy W.
Santa Barbara California 93110 (US)
• Robinson, McDonald
Santa Barbara California 93110 (US)
• Hammond, Robert B.
Santa Barbara California 93109 (US)

(74) Representative: Martin, Jean-Jacques et al
Cabinet REGIMBEAU
26, Avenue Kléber
F-75116 Paris (FR)

(56) References cited:
DE-B- 2 532 570          US-A- 3 191 055

• APPLIED PHYSICS LETTERS, vol. 53, no. 4,
July 25, 1988 W.Y.LEE et al. "Supercon- ducting
TICaBaCuO thin films with zero resistance at
temperatures ofup to 120 K" pages 329-331
• Nature vol.332 : March 3 1988, pages 138-139 ,
Sheng and Hermann
• Nature, Vol. 332, 10 March 1988, pages 138 - 139
• Römpp Chemie Lexikon, 9. Auflage (1990),
page 1195
• Handbook of Thin Film Technology (1970),
pages 4-10, 10-12, 10-17
• Applied Physics Letters, vol.53, no.6, August 8,
1988 I.SHIH et al. " Multilayer deposition of
Ti-Ba-Ca-Cu-O films " pages 523-525 *Abstract
page 523, left hand column, paragraph 2 - page
524, right hand column, paragraph 1*
• Applied Physics Letters, vol.53, no.4, July 25,
1988 B.F.KIM et al. " Superconducting thin
films of Bi-Sr-Ca-Cu-O obtained by laser
ablation processing " pages 321-323

## Description

CROSS-REFERENCE TO RELATED
APPLICATIONS

This application claims priority to U.S. application Serial N° 238,919, filed August 31, 1988, now issued as U.S. Patent N° 5 071 830 entitled "Metal Organic Composition Method for Forming Epitaxial Thallium-Based Copper Oxide Superconducting Films".

INTRODUCTION

Technical field

This invention concerns thallium based superconductors and devices employing such compositions.

Background

A recent scientific revolution in high temperature superconductivity has resulted from the discovery of many new metal oxide compounds, particularly copper oxide compounds, having dramatically increased superconducting transition temperatures ($T_c$). The initially discovered compounds were, for the most part, based on the combination of alkaline earth metals and rare earth metals, such as barium and yttrium in conjunction with copper. More recently, thallium based superconductors have been prepared, where the compositions have various stoichiometries of thellium, calcium, barium, copper and oxygen. The thallium materials have been more difficult to process, since the thallium Ca-Ba-Cu-O deposits are able to attain a composition which is liquid at processing temperatures. Thallium oxides have a relatively high vapor pressure at processing temperatures about 500°C and this has added to the difficulties in processing to ensure that the crystal structure has the correct stoichiometry. For the most part, sealed Au or Pt ampoules are used to control Tl volatilization by developing a controlled overpressure of Tl and oxygen above the film during high temperature processing.

Superconducting films are of great interest. However, in order to be useful, the films must be fairly uniform, be capable of carrying the current requirements of the device, have a superconducting transition temperature desirably aubstantially greater than the temperature of liquid nitrogen, have much lower RF surface resistance than copper, and be capable of reproducible preparation.

Relevant Literature

Ginley and co-workers at Sandia National Laboratories recently reported the preparation of superconducting thin films of the 2122 thallium compound ($Tl_2$, Ca, $Ba_2$, $Cu_2$, $O_8$). Jim Kwak at the same laboratory has reported polycrystalline thallium based films on yttria stabilized zirconia. Their films were prepared on yttria stabilized zirconia substrates by sequential e-beam evaporation of the individual metals on the substrate, followed by a post deposition reaction step in a closed platinum crucible. The films that were obtained were unoriented and exhibited a transition temperature of 97K. IBM has reported preparing oriented thin films of the 2223 and 2122 compounds by rf diode sputtering.

A large number of articles have been published concerned with the thallium compounds. Illustrative of these articles are Sheng and Hermann, Nature, (1988) 332:55-58, generally disclosing TlCaBaCuO superconductors ; Sheng and Hermann, Nature, (1988) 332:138-139, generally disclosing TlCaBaCuO superconductors ; Ginley et al., Physica C, (1988) 152:217-222 ; Superconductor Week, Vol. 2, No. 18, May 9, 1988, reported that Sandia had prepared unoriented polycrystalline Tl thin films that have reached critical current densities of 110,000 $A/cm^2$ at 77K with a $T_c$ at 97K. In the presence of a high magnetic field (6 Tesla), a critical current density of $1 \times 10^6 A/cm^2$ at 4K was observed.

Venkatesan et al., Appl. Phys. Lett. (1988) 52:1193-1195, and Wu et al., Proceedings of SPIE Symposium on High $T_c$ Superconductors, Newport Beach, CA March 1988, report the use of pulsed laser deposition for preparation of high $T_c$ superconducting thin films. Venkatesan et al., and Wu et al., supra claim to have achieved YBaCuO films that are superconducting after deposition at 650°C, followed by oxygen annealing at 450°C. Witanachchi et al., (Appl. Phys. Lett., in press) report that with the addition of DC bias plasma during laser ablation of high $T_c$ superconducting YBaCuO thin films, in situ superconducting films can be achieved at substrate temperatures as low as 400°C. Lee et al, Applied Physics Letters, Vol. 53, No. 4, July 25, 1988, provides various characterizations and structural descriptions of thallium containing high temperature superconductors.

SUMMARY OF THE INVENTION

Superconducting thallium based films on substrates are provided, employing processes using growth from a liquid phase onto a crystalline substrate. Various techniques and conditions are provided to produce crystalline layers of superconductive material onto the substrate, obtaining epitaxial growth.
The products have superior superconductive properties as evidenced by surface impedance, with the products finding particular applications as components of electronic devices for microwave and millimeter wave applications.

BRIEF DESCRIPTION OF THE DRAWINGS

Fig. 1 is a diagrammatic side view of a sealed vessel assembly for production of a superconductor film ;
Fig. 2 is a cross section view along lines 2-2 of Fig. 1;

Fig. 3 is an alternate embodiment employing a device using infrared heat to produce a superconductor film;

Fig. 4 is a diagrammatic view of an alternate embodiment using a tilting vessel for coating a substrate with a superconductor film;

Fig. 5 is a schematic view of a narrow band microwave filter; and

Fig. 6 is a schematic view of a digital instantaneous frequency measurement device.

## DESCRIPTION OF THE SPECIFIC EMBODIMENTS

Compositions and devices are provided comprising a thin film thallium based superconductor composition. The compositions comprise an average composition $Tl_a Ca_{n-1}, Ba_2 Cu_n O_{2n+4}$ as films on a variety of substrates, particularly crystalline substrates. Methods which have been employed to produce the films are both chemical and physical deposition techniques and include sol-gel and laser ablation techniques as preferred. The superconductor layer coated substrates find use as components in a wide variety of electronic devices, particularly with microwave and millimeter wave applications.

The films which are provided are primarily thallium-(calcium)-barium-copper oxides, with a stoichiometry which may include 2021, 2122, 2223, or such other stoichiometries as may be employed. The films will be oriented films, so as to have a substantially uniform crystallinity. The films may be comprised of a single crystal or a plurality of crystals joined at their grain boundaries. The films will be highly oriented with the c-axis substantially normal to the surface of the substrate as demonstrated by X-ray analysis or electron beam channeling techniques. For the most part, single phase films will be obtained, although, as desired, mixtures of two of the phases or related phases may be achieved within the film. For some applications polycrystalline films may be prepared.

The thickness of the film may be controlled. The film may be as thin as one layer, where the layer includes all of the necessary planes to obtain superconductivity, generally from about 30-50 °A, or may be as thick as two micrometers or greater, depending upon the particular application. The thickness of the film is primarily a practical consideration, rather than a significant limitation of the procedures employed.

For many uses, a fraction of a micrometer thickness will be employed, generally in the range of about 0.1 - 1 $\mu$m. The film will have a superconducting transition temperature of at least 75K, more usually 90K, preferably at least about 100K, more preferably about 115K, and particularly preferred at least about 122K, where the transition temperature has so far been substantially less than about 150K. 2122 composition films can be achieved with a $T_c$ of at least 110K and 2223 films with a $T_c$ of at least 122K. The superconducting transition temperature should be as high as feasible, though in some situations one parameter may be compromised for another parameter. For the most part the films will be used at temperatures in the range of about 60 - 100K.

The films will usually have critical current densities at 77K of at least about $10^3$ A/cm$^2$, usually at least about $10^6$ A/cm$^2$. For microwave and millimeter wave applications, the surface resistance or impedance will generally be less than about $10^{-3}\Omega$, more usually less than about $10^{-4}\Omega$, at 10 GHz and at a temperature above 50K, preferably above about 75K.

The films will be substantially free of contaminants, having less than about 10 wt. %, preferably less than about 5 wt. % of material not involved with the superconducting crystal. For the most part, films will be at least about 0.5 cm as their smallest dimension and 3 cm or as large as 5 cm or more as their smallest dimension in the a,b plane.

The films will be of high quality as demonstrated by low lattice fault densities. By low lattice fault density is intended a sufficiently low fault density to demonstrate the intrinsic superconducting physical transport properties and sufficient to achieve required device property requirements. In addition, smooth surface morphologies can be achieved as well as uniform thickness. See Forsyth, Science (1988) 242:391-399, for a description of surface morphology of Nb$_3$Sn superconductors and the effect on electromagnetic properties.

Furthermore, the films may be grown epitaxially on substrates, where the crystal lattice of the superconductor does not differ by more than about 10% from that of the substrate. That is, along the a-axis of the crystal, the difference in lattice parameter between their a axes (($a_{s\text{-}ubstrate}$-$a_{superconductor}$)/$a_{substrate}$) may differ by up to about 10% and still obtain epitaxial growth. However, with the subject film in addition to being highly oriented, one may also achieve epitaxy by appropriate choice of substrate.

Epitaxial Tl 2223 and 2122 films on {100} surfaces of MgO having intentional deviations of a few degrees from nominal orientation on axis can be beneficial. In a Tl 2223 film the <001> axis (lattice parameter, c = 36.26 A ) is substantially coincident with the <001> axis of the MgO substrate or is at a systematic angular deviation in epitaxy with large lattice mismatches. Besides the correlation of the <001> axes, the epitaxial Tl film has its <100> and <010> axes parallel or at a systematic deviation to the analogous axes of the MgO substrate.

Various substrates including single crystal, polycrystalline, and amorphous substrates may be employed, depending upon the particular use for the coated substrate, whether one wishes epitaxy, the particular processing conditions, and the like. Substrates which may find use include magnesium oxide, yttria stabilized zirconia, sapphire, alumina, silicon, lanthanum aluminate, strontium titanate, gallium arsenide, lanthanum gallate, and calcium fluoride.

Various techniques may be employed for producing thallium based superconductors on a solid substrate.

Techniques which have been employed in the past with other superconductor metal oxide compositions include laser ablation, thermal evaporation, liquid phase epitaxy, electron beam, magnetron sputtering, and chemical vapor deposition. Illustrative of methods for producing the subject epitaxial layers are liquid phase thermal processing of sol-gel coating and laser ablation deposited coating.

Liquid phase film formation involves heating a deposited film to form a liquid coat on a substrate, whereupon the metal oxides crystallize from the liquid onto the substrate to form the superconductor layer. A liquid composition can be formed with Tl oxide, by itself or in combination with calcium oxide, as the solvent, with the other oxides becoming dissolved in the Tl oxide-containing liquid at an elevated temperature and subsequently crystallizing with the correct stoichiometry. Upon cooling, evaporation of the solvent, or chemical precipitation, the metal oxides crystallize to form a crystalline superconductor layer. Depending upon the substrate, the layer may also be epitaxial. One need not use the oxides initially, but can use metal compounds which may serve as the source of the metals in the liquid phase, where the counterions and conditions result in the formation of the desired oxide. The process may be divided into the following components: (1) Coating of the substrate; (2) Environment during crystallization; and (3) Thermal process conditions such as temperature, pressure, time; and (4) Miscellaneous other considerations.

For epitaxial growth, there will have to be pretreatment of the substrate to achieve consistent results. The liquid phase epitaxial procedure employs highly polished surfaces of the substrate. The surface may be polished mechanically or chemically, preferably both. Single crystal substrates are employed to obtain epitaxial film structures. For example, single crystal magnesium oxide <100> may be polished using hot concentrated phosphoric acid, for example, at about 80°C with 85% phosphoric acid for 10 min, or by lapping the surface flat and to the desired orientation and then immersing in conc. phosphoric acid at 50°C for 1-3 min. The resulting chemically polished crystal surface should be very clean, and provide a substantially defect free surface. The particular manner in which the surface is polished is not critical to this invention. Desirably, as exemplary of magnesium oxide, the (100) plane surface will be employed.

Coating of the substrate may be achieved in a variety of ways. One technique is to use chemical precursors, which upon pyrolysis may provide the desired oxide as a coating. Another technique is to employ a liquid comprising a solution of the metal oxides having an appropriate stoichiometry for production of the superconductor. Other techniques have been indicated, which involve vapor phase deposition. The first technique to be considered will be employing metallo-organic precursors to produce the oxides.

A sol composition is prepared employing metal soaps providing for the appropriate stoichiometry. The soaps will be carboxylates of at least about 6 carbon atoms, preferably at least about 8 carbon atoms, and usually not more than 16 carbon atoms, more usually not more than 12 carbon atoms. Conveniently, the 2-ethylhexanoates have found use, although neodecanoates, or other branched chain, particularly alpha-branched chain fatty acids may be employed. The metal soaps are prepared in accordance with conventional procedures. The soaps are dispersed in an appropriate medium, particularly hydrocarbons or halohydrocarbons boiling in the range of about 40°C to 100°C, such as chloroform, toluene, xylene, benzene, methylenedichloride, etc., and the mixture made homogeneous by agitation, for example shaking, for several hours. Adjuvants may be added, such as thickeners, e.g. polysaccharides or ultra-high molecular weight polymers. The resulting solution and/or dispersion is then coated onto the substrate.

Coating can be achieved by putting the viscous sol onto the surface to be coated and spinning the surface by centrifugation for a short time to ensure the substantially uniform distribution of the film. Alternatively, the substrate may be dipped into or sprayed with the dispersion, protecting those areas of the substrate which are not to be coated. Any technique which allows for substantially uniform coating of the film on the substrate may be employed.

The coated substrate is then pyrolyzed for a short time at an elevated temperature, generally in the range of about 150°C to 500°C, preferably in the range of about 150°C to 300°C. Tl volatilization can occur at temperatures as low as 100°C, so that short process timing and Tl overpressures and oxidizing atmospheres are employed to control phase formation and to limit Tl loss and formation of undesired second phases in the film. The pyrolysis time and temperature should be selected to substantially ensure decomposition of the fatty acids, so as to leave a thin film of metal oxides, the pyrolysis occurring in the presence of oxygen, conveniently air. The procedure may be repeated as many times as desired, in order to enhance the thickness of the metal oxide film.

Desirably, each subsequent pyrolysis may be carried out at a lower temperature than the initial pyrolysis, where the initial pyrolysis is carried out in the upper portion of the temperature range, 250-450°C, and the subsequent pyrolyses are carried out at a temperature in the range of about 200-350°C. Usually, at least about 60% of the volatile organic material is removed and by extending the heating period, a constant weight can be realized. Care must be taken to minimize thallium volatilization when pyrolysing above 300°C.

The film, deposition and pyrolysis procedure will be carried out at least once, more usually twice, and may be five times or more, usually not more than about four times.

The thickness of each layer will depend upon a number of parameters: the viscosity of the sol, the time for spinning, the revolutions per minute, the temperature at which the substrate is spun, and the like. Where other techniques are used to provide the coating, such as dipping, spraying, spreading with a blade, or the like, different parameters may be involved.

Once the substrate surface has been coated to the desired degree, the substrate may then be introduced into a closed inert vessel, containing pellets with the appropriate molar ratio for maintaining the stoichiometry of the film in the presence of a source of oxygen during heating. The molar ratio of the pellets is determined by the phase that is desired within the film. The film composition after heating is substantially affected by the geometry and temperature of the source material and the resulting Tl overpressure.

Maintenance of a controlled thallium overpressure may be achieved in a variety of ways. The simplest way may be to coat the layer containing the mixture of oxides with a thallium oxide layer, so that vaporization of the thallium oxide overcoat provides for thallium overpressure. To ensure sufficient thallium for incorporation in the superconductor layer, the housing for the thermal treatment of the superconductor layer should desirably be relatively small, so that a relatively small volume is occupied by the vapor. By relatively small is intended a volume of about 0.001 to 10 times the size of the substrate. In addition, compared to the surface of the superconductor layer, the surface of the thallium source should be relatively large, at least about one and a half times, preferably about two times, and maybe five times or more. In addition, the thallium oxide is desirably combined with calcium oxide and copper oxide, where the composition may be varied, depending upon whether the source is present during crystal growth or for stabilizing the thallium superconductor material after it is in the correct phase.

Conveniently, in the gas phase, air, pure oxygen, or other source of oxidizing oxygen may be employed, e.g., hydrogen peroxide or ozone during heating. The pellet composition will vary depending upon the particular thallium superconductor one wishes to prepare. For example, for the 2223 composition, the pellets will have a Tl: Ca: Ba: Cu 1:3:1:3 molar ratio. The inert tube is conveniently a passivated noble metal, most conveniently gold or plated quartz, which may be externally reinforced to support the pressures during the reactions.

The processing temperature will be at least about 600°C, more usually at least about 630°C, and not more than about 950°C, frequently in the range of about 800-900°C. The temperature may be monitored in any convenient way, conveniently a thermocouple. Usually, the temperature will be achieved rapidly, generally under five minutes, preferably under three minutes, more usually from about 0.5-3 minutes. Slower heating rates (20°C/min) may be employed to give continuous superconducting films of smaller grain size. The tube may be heated to a temperature or temperatures in the range indicated above, generally for sufficient time to ensure complete pyrolysis of any residual carbon compounds and allow for the atoms to assume the proper lattice structure. Generally, the time at high temperature will be at least about 0.5 minute and not more than about 60 minutes, more usually in the range from about 0.5 to 25 minutes, preferably from about 0.5 to ten minutes. At the end of this time, the tube may be removed from the heating source and allowed to cool. Normally, there need not be any effort at rapid quenching, so that the tube may be allowed to sit in a room temperature environment, without providing for a rapid reduction in temperature.

A second preferred procedure for preparing the subject films employs laser ablation. Laser ablation can be used either to coat the substrate at room temperature in preparation for the thermal process described above, or can be used to deposit and form the superconducting phase in one step at elevated temperature.

Laser ablation is achieved by preparing an appropriate target. The apparatus for the most part, is conventional and is described in Wu et al, _supra_. A target is prepared by placing the appropriate composition of metals or metal oxides on the surface of a support which can be rotated at a controlled rate. The target on its support is placed in a vacuum chamber having a quartz window, where a laser beam of appropriate energy and wavelength impinges on the target causing a plume of ablated vapor normal to the target suface. The substrate is placed substantially normal to the direction of the plume, so as to receive the atoms in the plume, where the atoms bind to the surface of the substrate. The substrate is maintained at room temperature or at an elevated temperature depending on whether the goal is an amorphous or a crystalline deposit.

The laser ablation target can conveniently be made in the same manner as the sol-gel coating described earlier. Thus, a uniform film of the various carboxylates can be prepared and pyrolyzed as described previously to produce the desired oxide mixture. Pyrolysis can be carried out in the presence of oxygen, so as to ensure the formation of the desired metal oxides in their proper oxidation state. Alternatively, the target can be made from pressed and sintered powder or from hot pressed powder.

The laser energy density on the target will generally be from about 1-3 $J/cm^2$. The film on the target will have the same metal molar ratio as the intended composition on the substrate 1 $cm^2$ to 63 $cm^2$ in surface area and about $25\mu$ to .7 cm thickness.

The laser may be focused to cover various areas of the target. The laser may impinge upon the surface over a wide range of angles from a minimum of about 2° up to 90°. A typical impingement angle is about 25°. The area impinged by the laser will generally be at least about 2 $mm^2$ and not more than about 50 $mm^2$. A typical area is about 15 $mm^2$. The ratio of length to width will depend upon the angle of impingement, and will generally be at least 2 to 1, and not more than about 20 to 1, more usually not more than about 10 to 1. By employing an energy in the range of about 2 $J/cm^2$ per pulse, one can deposit about one monolayer, generally about $3 \times 10^{-10}$m thick

onto the substrate with each pulse. By controlling the number of pulses per second, which would generally range from about 0.5 to 50, one can achieve an accretion on the substrate of about $0.1\mu m/min$.

The target will usually be relatively close to the substrate, usually not less than about 2cm and not more than about 10 cm, preferably about 6 cm. The chamber will be evacuated to under about 500mTorr, preferably from about 2 to 200mTorr, more preferably about 100 to 200mTorr. Various inorganic oxidizing gases may be present, such as oxygen, air, hydrogen peroxide, ozone, nitrogen oxides, such as nitrous oxide or the like, where the inorganic oxygen source can be activated by virtue of the laser beam or an independent energy source. For example, an oxidizing gas source may be directed toward the layer on the substrate where the gas has been activated, for example, oxygen activated by passing through an electric field or laser.

For growth of crystalline superconducting films the substrate will generally be maintained at a temperature in the range of about 450-750°C, preferably about 500-650°C. The temperatures which are maintained will allow for the atoms to form the proper crystal structure, but should be kept as low as possible to minimize interdiffusion between the film and substrate and to minimize thallium loss by vaporization. The lower the temperature which is used for the substrate, the slower the deposition rate which should be employed. Alternatively, one can increase the energy of the atoms and molecules in the plume by providing for a plasma in the ablated plume. This additional energy increases the atoms' ability to form the proper crystal structure at low temperature, and increases the rate at which the film may be grown.

In some instances, where thallium may be lost because of its higher vapor pressure, it may be desirable to increase the amount of thallium in the target. Alternatively, thallium loss can be minimized by maintaining a higher oxidation potential in the apparatus.

It may be desirable to sequentially ablate one or a combination of metals or metal oxides, so that layers of different composition are deposited sequentially to provide the different atomic layers of the crystal.

Besides deposition on elevated temperature substrates as described above, laser ablation can be used to deposit onto room temperature substrates prior to thermal processing. Laser ablated films on room temperature substrates are dense, uniform and high purity, but are not crystalline. These amorphous films, when heated, form liquid and then solid crystalline phases in the manner previously described for chemical processing. The kinetics of liquid phase formation is somewhat different for the two kinds of films because the chemically prepared films tend to be highly porous, and may contain some residual carbon before thermal processing.

Layers of different composition may be employed. Of particular interest is having an initial layer of thallium oxide, preferably a combination of thallium oxide and calcium oxide, with a second layer comprising at least copper and barium oxides, desirably comprising thallium and calcium oxides as well. These layers can be achieved as described above, using the various processes which allow for the independent application of different compositions as layers on the substrate. For example, with the sol-gel technique, one could first provide for a layer of thallium and calcium carboxylates, which may or may not be pyrolysed prior to coating with a layer of carboxylates of all of the metals.

An alternative procedure for coating the substrate, may employ the physical method of tilting. By employing a boat which can be tilted, so that the liquid composition can be kept away from the substrate, a liquid of the various oxides may be produced. Once the liquid is formed, the boat may be tilted, so that the liquid now coats the substrate, which is in the other part of the boat. Desirably, the substrate may be positioned, so it is at an angle to the bottom of the boat, with the higher end near the wall of the boat. The conditions under which the coating is carried out would provide for a rapid rise to a temperature in the range of about 500 to 880°C, at which point the oxides would be in the liquid form. The boat can then be tilted and cooling begun at a relatively slow rate, in the range of about 0.5-10°C/min until the temperature has dropped at least about 10°C, preferably not more than about 50°C, when the temperature is in the range of about 490-860°C. At this point, the boat would be tilted back to the original position, where the substrate was no longer in the liquid, and the substrate would be rapidly cooled at a rate of at least about 10°C/min, preferably at least about 20°C/min to room temperature.

Various configurations may be employed during thermal processing between the source and the superconductor film. The source should not be allowed to contact the superconductor film. The configurations may allow for the source being in a confronting relationship to the superconductor film. For example, a substrate coated with the source may be spaced from the substrate coated with the superconductor film by a spacer (typically 5 microns or greater in thickness), where the source and film are in a confronting relationship.

An alternative configuration would have the superconducting film on a substrate in a container, where the source is displaced from the superconductor film and is maintained at a temperature differential from the superconductor film. Thus, by varying the temperature of the source, different thallium overpressures would be achieved, so as to ensure the proper Tl stoichiometry at the superconductor film surface.

Various regimens may be employed for producing these superconducting films and for use in a postannealing of the superconducting material. By employing schedules for heating and pressure that inhibit the evaporation or boiling of the liquid in the film prior to formation (precipitation) of the superconducting material, one can provide for condensation of Tl source material, so as to provide for precipitation of the superconducting phase, and can minimize or prevent the formation of nonsuperconducting oxide compositions.

One protocol would initially provide for a pressure of about 3 atm with a rapid rise in temperature from room temperature to 850°C, at about 50°C/sec rise, so that the temperature is reached in about 15 to 20 sec, maintaining the superconducting film at this temperature, where approximately 100 sec will have elapsed from the initiation of heating, allowing the superconductor to cool over a period of about 5 to 10 sec to a temperature of about 550°C and maintaining the temperature for an additional 100 sec, followed by cooling to room temperature. During this time, a different heating profile is employed for the source material, where the source is heated at about the same rate along with the superconductor film, but is maintained at the high temperature for about 5 to 25 sec longer than the superconducting film, so that the overpressure is maintained relatively constant while the superconducting film is undergoing its initial cooling, followed by dropping the source temperature by about 100°C and maintaining this temperature during the annealing of the superconducting layer. The temperature is then allowed to drop to room temperature along with the superconductor layer. The pressure profile would be to maintain the elevated pressure until the annealing temperature has been reached and then allow the pressure to drop to 1 atm.

Where the source and superconducting layer are both maintained at the same temperature, a different protocol would provide for heating at about 40 to 70°C/min to 800°C, where the temperature is achieved in from about 15 to 40 sec, preferably about 20 to 30 sec, while maintaining an oxygen pressure at 3 atm. The elevated temperature is maintained for an additional 60 sec and then reduced at a temperature drop from about 5 to 20°C/sec to room temperature. The pressure profile differs in being maintained at the elevated pressure for about 60 sec, and then allowed to drop to 1 atm over about 10 to 20 sec. By adjusting the liquid composition, growth may be achieved at one atm pressure.

Parameters for a thermal anneal will vary from the preparation of the superconducting film. For the anneal, the superconducting film is rapidly heated to a temperature in the range of about 500 to 750°C, generally over a period of about 10 to 30 sec. The temperature will then be maintained, ± 15% for a period of about 5 to 60 min, preferably from about 15 to 45 min in an oxygen atmosphere while in the presence of a thallium source. The temperature for the source will be higher by at least about 50°C, preferably from about 100 to 150°C higher than the superconducting film. The temperature of the source will be heated analogously to the superconducting film, so that the ultimate temperature for the source is reached at or shortly after the temperature for the film is reached. The temperature for the source will be maintained substantially constant during the period of annealing and will then be allowed to cool at about the same time as the superconducting film back to room temperature, as well as at about the same rate. Desirably, cooling of the source will begin shortly before the cooling of the superconducting film, usually from about 0.5 to 5 min prior. During the annealing, an elevated pressure may be employed, usually about 1.5 to about 2.5 atm, preferably up to about 2 atm.

Localized effects can be achieved by employing infrared heating. For example, the substrate with the pre-superconductor or precursor film could be placed in an enclosure having an infrared transparent window above the film and having a small volume relative to the substrate. By employing infrared heat, vaporization would occur in a small volume with a rapid increase in pressure. Furthermore, the assembly could be introduced into a pressure vessel, which would also have an infrared transparent window, so that the entire assembly could be pressurized. In this way, the gas environment in which the superconductor film is formed would be rapidly saturated with thallium oxide vapor. The process may be carried out at atmospheric or superatmospheric pressure.

By placing the substrate on a large thermal mass base, and using infrared heating, a heat flux will occur at the substrate precursor film interface, since the substrate will have higher thermal conductivity than the precursor or the intermediate liquid composition. Thus, there will be a temperature gradient in the film and substrate, where the precursor film will be at a higher temperature than the substrate. The cooler substrate can then provide a site of nucleation for the formation of the superconductor film.

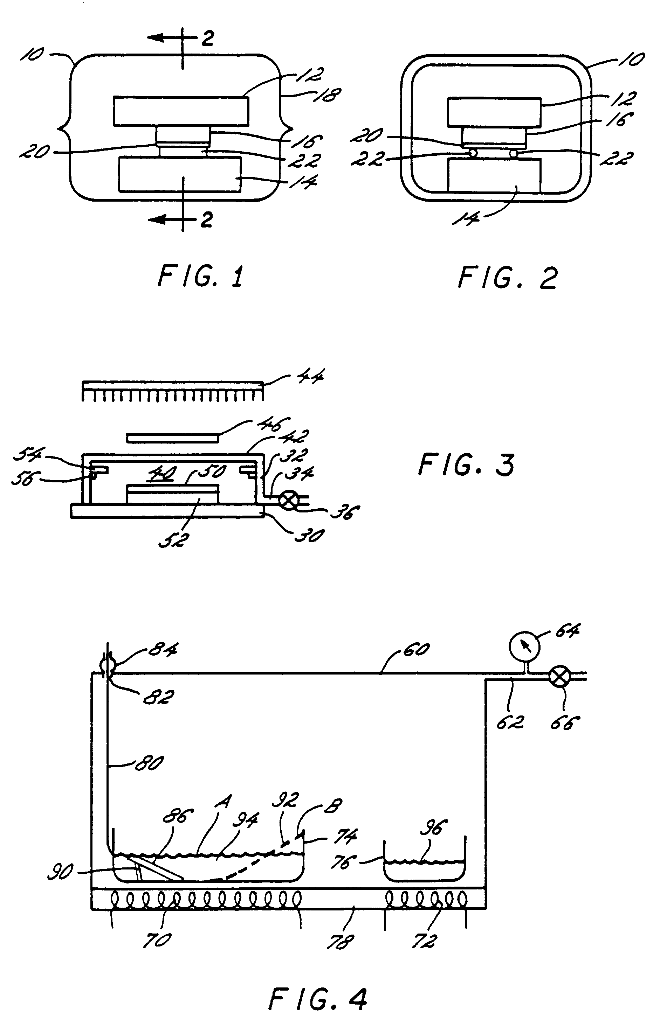

For further understanding of the invention, the drawings will now be considered. In Figures 1 and 2 are depicted different views of tubular devices and arrangements for production of superconductor films. The gold sealed vessel 10 houses thallium pellet sources 12 and 14. A substrate 16 separates pellet 12 from the superconductor layer precursor 20. A wire horseshoe spacer 22 prevents the pellet source 14 from touching the superconductor layer 20. Prior to sealing tube 10, the various components may be assembled to provide the indicated assembly and introduced into the housing 10. The housing may then be sealed and introduced into a furnace where it is rapidly heated to the desired temperature and maintained at that temperature. However, it is not necessary to seal the pouch in order to prepare high quality films using this process geometry. Usually, a small amount of air or oxygen will be allowed to remain in the sealed housing 10. Upon heating, the pellet sources will partially evaporate, so as to maintain a thallium oxide overpressure in the housing 10, to prevent significant evaporation of thallium oxide from the superconductor precursor layer. After sufficient time for the superconductor layer to form, the tube may be allowed to cool by turning off the furnace and letting the furnace chamber come to room temperature.

In Figure 3, an alternative embodiment is provided, where infrared heat is employed to produce the desired temperature. Mounted on a base 30 is cover 32 having conduit 34 and valve 36 for evacuating or pressurizing the chamber 40. The cover 32 has an infrared transparent ceiling 42 to allow for transmission of infrared rays into chamber 40. An infrared source 44 is provided which is able to irradiate the entire chamber. A removable mask 46 is provided which when in place prevents radiation from heating the superconductor film precursor 50. The superconductor film precursor 50 is coated onto substrate 52 which sits on base 30. A thallium oxide ring 54 is mounted on support 56 inside the chamber, where the thallium ring will be exposed to the infrared radiation when the mask is in its position.

In preparing a superconductor film, one would place the substrate 52 coated with the superconductor precursor film 50 onto the base 30 and then mount the cover 32 on the base. The chamber may then be filled with oxygen and irradiation with the infrared lamp 44 begun, with the mask in place. When a sufficient thallium oxide partial pressure has been achieved, the mask may be removed and the precursor film 50 heated to an elevated temperature, so as to provide for formation of the superconductor film. After sufficient heating, the lamp 44 may be turned off, the chamber 40 allowed to cool to room temperature, evacuated, and the cover removed for isolation of the superconductor film.

In Figure 4, an alternative embodiment is indicated, where one or more substrates may be coated with a superconductor film precursor, where the substrate may be repetitively coated, until a layer of the desired thickness has been achieved. A housing 60 is provided having conduit 62 with pressure gauge 64 and valve 66. The base of the housing 60 has two heaters, 70 and 72 which can provide heat to vessels 74 and 76 respectively. Attached to one end of vessel 74 is rod 80 which extends through orifice 82 outside of housing 60. Seal 84 prevents the introduction of air or loss of vapors into housing 60. Substrate 86 is situated in vessel 74 supported at an angle by mount 90. By means of rod 80, vessel 74 may be moved from position A, where the surface of the liquid precursor to the superconductor film is substantially parallel to the base 78 of housing 60. In this position, the substrate 86 is immersed in the superconductor precursor liquid. By lowering the temperature or evaporating some of the solvent, crystallization of a superconductor film on the substrate is induced. By raising the rod 80, or tilting the entire apparatus, one can then move the liquid to position 92 indicated by the broken lines B, so that the substrate 86 and superconductor film is no longer coated with the superconductor precursor liquid 94. Vessel 76 will contain thallium oxide liquid 96 which may serve to provide a thallium oxide overpressure in the housing 60. The temperature of the thallium oxide liquid 96 may be maintained at a lower temperature from the superconductor precursor liquid, since it will be solely comprised of thallium oxide, and can be used to control the overpressure in the housing 60.

The subject device components can be used in a wide variety of devices. Because superconductive layers have low microwave surface impedance, they find use in numerous microwave and millimeter wave applications. The subject elements comprising the substrate and film, by appropriate choice of substrates, may find use in radio frequency cavities and resonators, microwave shielding, antennas, in transmission lines, employing different structures, such as coaxial, microstrip, coplanar wave guide, coplanar strip line, inverted or suspended microstrip, and the like. The devices find use in signal communications or delays, filters, resonators and oscillators, circuit interconnections, power combiners, and antenna feeds.

For a narrowband microwave filter with superconducting resonator elements, the specifications could be:

Transmission medium: microstrip coupled lines (5-15 resonator elements)
Bandwidth: 0.1-10% at the center frequency ($f_o$)
Dimensions:

Superconductor thickness (t)=I micron
Relative dielectric constant
($\varepsilon_r$)=9.65 (MgO)
Loss tangent=.0002 (MgO)
Substrate height (h)=0,635 mm (25 mils)
Spacing (s)= 0,254 - 3,81 mm (10-150 mils)
Line width (w)= 0,0254 - 1,016 mm (1-40 mils)
Length (1), 0.25 guide wavelength at $f_o$, 1=2,90 mm (114 mils) at 10GHz

Package dimensions:

X=25 mm (1 in.)
Y=25 mm (1 in.)
Z=6,25 mm (0,25in).

The filter is packaged in a shielded case and cooled to 77°K and connected with an SMA coaxial connector to other hardware part.

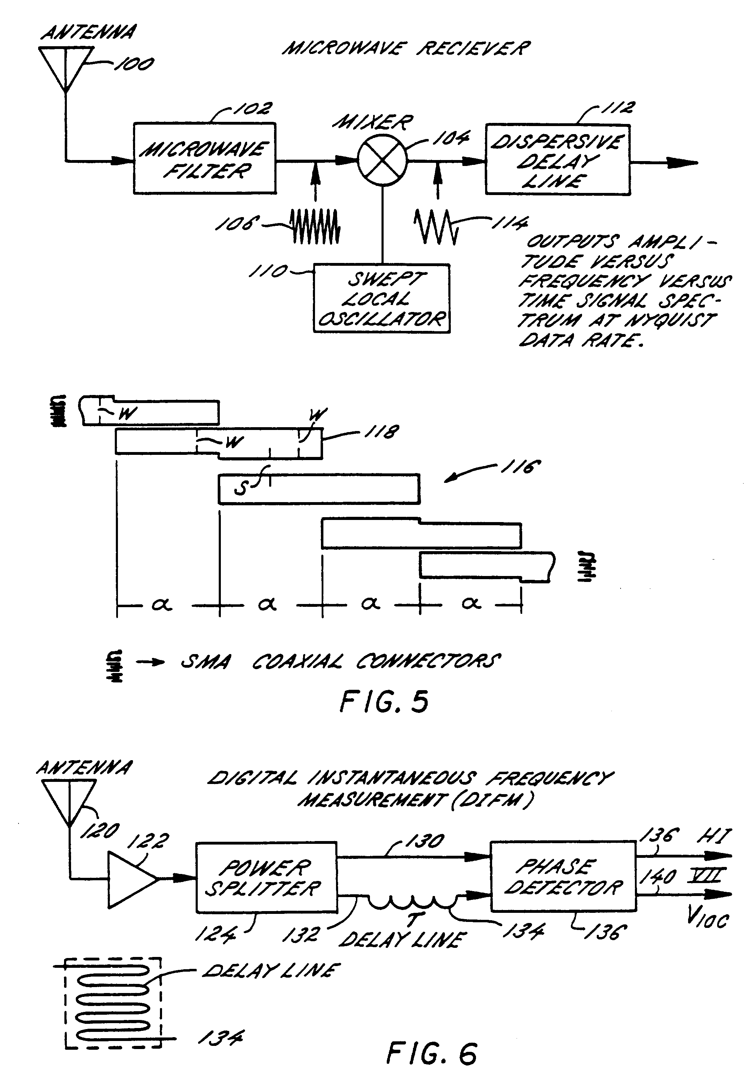

An exemplary narrow band microwave filter with superconducting resonator elements is depicted in Figure 5. The filter comprises antenna 100 which feeds the signal to microwave filter 102. The signal from microwave filter 102 is fed to mixer 104 in conjunction with signal 106. A swept local oscillator 110 also feeds a signal into the mixer 104, which provides an output to dispersive delay line 112 in conjunction with signal 114. The superconducting resonator elements 116 are shown in an array where "w" is line width, "s" is spacing and "l" is length. The low loss of the narrow band microwave filter enables the microwave receiver to have a relatively higher signal to noise ratio. The dispersive delay line is used to process long pulses (higher energy) as if they were short pulses (higher range resolution). First described by R.H. Dicke, U.S. Patent No. 2,624,876, issued January 6, 1953.

Delay lines are an integral part of a digital instantaneous frequency measurement (DIFM) component. The delay line specifications could be as follows:

Dimensions:

Superconductor thickness (t)=0.015 $\mu$m - 2 $\mu$m
$\varepsilon_r$=9.65 (MgO)
Loss tangent=0.0002 (MgO)
Substrate height (h)=0,635 mm
Line width (w) = 1 $\mu$m - 1 mm (0.04 - 40 mils)
Total length (1)=20 mm

Package dimensions:

X=25 mm (1in.)
Y=25mm (1in.)
Z=6,25 mm (0,25 in.).

The delay line can be packaged in a shielded case thermally attached to a 77°K cold finger with SMA coaxial connectors interconnecting the delay line within the DIFM.

A digital instantaneous frequency measurement is diagrammatically depicted in Figure 6. The antenna 120 feeds a signal to a diode 122 which feeds the signal to power splitter 124. The power splitter 124 outputs directly to phase detector 126 through lines 130 and 132 which comprises delay line 134 comprised of the superconductor film. The outputs of lines 130 and 132 are fed into phase detector 126, which then outputs signals 136 and 140 to video 142.

The following examples are offered by way of illustration and not by way of limitation.

EXPERIMENTAL

The individual Tl, Ca, Ba and Cu metal carboxylate compounds were prepared following established procedures. The resulting solutions of metal soap compounds in chloroform were reduced in volume by evaporation and analyzed by atomic absorption for their metal contents. These precursor solutions were then used to prepare the precursor sol by combining 5g copper 2-ethylhexanoate, 3.29g barium 2-ethylhexanoate, 3.14g calcium 2-ethylhexanoate, and 8.462g thallium 2-ethylhexanoate in 5 ml of chloroform. The precursor stoichiometry was $Tl_2Ca_2Ba_2Cu_3$. The solution was mixed by shaking for several hours. This precursor solution was spun onto a single crystal yttria-stabilized zirconia (<100> orientation) substrate at 4000 rpm for 30 sec followed by pyrolysis at 400°C for 5 min. This spin/pyrolysis procedure was repeated twice more at 250°C. Oxide pellets with a molar ratio Tl:Ca:Ba:Cu-1:3:1:3 were prepared by mixing the individual oxides together by grinding and then pressing uniaxially in a Carver press. The pellets and the coated substrate were placed in air in a 6.25 mm $\frac{1}{4}$" diameter gold tube and hermetically sealed. The sealed gold tube was attached to a thermocouple probe using wire and inserted into a preheated tube furnace. The material was brought to a temperature of 855°C in 2 min and held for 10 min. The sample was then removed from the furnace and cooled to room temperature. The entire film processing procedure required about 15 min to complete.

Optical micrographs of the pyrolyzed film revealed the presence of a large number of plate and needle-like (plate on edge) structures throughout the film. Both structures were found to have, by energy dispersive x-ray analysis, the 2223 composition. Scanning election microscopy of the film showed the plate-like morphology of the superconducting 2223 compound. The micrograph also showed the spherical Ca/Tl oxide deposits that inhabit regions immediately adjacent to the plate-like structures. The composition of the plate was determined by SEM-EDX (scanning electron microscopy energy dispersion x-ray spectroscopy) to consist of 12 atomic percent Ba, 12 Tl, 12 Ca and 20 Cu. The compositional analysis results were consistent from area to area and are consistent with the material possessing a 2223 metal stoichiometry. The highly oriented nature of the 2223 film is indicated by the large enhancement of the <001> reflections in an x-ray diffraction scan. A minor peak at 6° was indicative of a very small amount of the 2122 phase in the film. The temperature dependent magnetic susceptibility measurement was performed on the film on the assumption that the material consisted of a 2 micron thick fully dense film. It was calculated that greater than 60% of the material became superconductive.

To prepare the 2122 composition, the above procedure was repeated, except the composition of the source material corresponded to a Tl:Ca:Ba:Cu atomic ratio of 2:2:2:3. The temperature was slightly modified to 860°C for reaction and the substrate which was employed was a magnesium oxide substrate single crystal that had been chemically polished using hot concentrated phosphoric acid as described previously (See Sanywal and Sutaria, J. Mater. Sci. (1976) 11:2271-2282) to provide a substantially defect free (<100>) surface.

Optical micrographs of the pyrolyzed film revealed the presence of a large number of plate-like structures throughout the film. These structures were found by SEM-EDX to have a chemical composition corresponding to the 2122 material. SEM of the film clearly showed the plate-like morphology of the superconducting 2122 compound. The film was highly c-oriented as indicated by highly enhanced <001> reflections. The film was found to be epitaxial by comparing electron channeling patterns of the single crystal substrate with that of the film in various regions. The morphology of the film is strongly indicative of the presence of an intermediate liquid phase during processing. The surface of the film (which resembles thin film surfaces obtained by liquid phase epitaxial growth techniques), was analyzed by EDX to have the correct cation stoichiometry for the 2122 compound.

Electron beam channeling patterns were obtained from many representative areas within the film. Electron channeling patterns of the film revealed that the orientation of the a, b plane within the 2122 film was identical to that of the substrate in many areas throughout the film. In a few areas, the channeling pattern of the film was slightly misoriented (by a constant amount) from the substrate, perhaps indicative of a buildup of strain or dislocations at the film/substrate interface due to lattice mismatch which is approximately 9%. The lattice registry with the surface was maintained not only at layers close to the magnesium oxide substrate, but also at the top of plates many microns from the substrate surface.

To deposit a thallium-based superconducting film by PVD, for example of the 2223 composition, a substrate is loaded into a specially designed vacuum chamber, and held in position where it faces a target approximately 6 cm away. The vacuum chamber is evacuated to a pressure of less than $1 \times 10^{-6}$ torr, then back filled to $5 \times 10^{-3}$ torr with oxygen, while the substrate is heated to a temperature between room temperature and 400°C. Material is then vapor transported from the target to the substrate by laser ablation, using a laser energy density on the target of 1.5 to 2.0 Joules/cm$^2$. The laser is pulsed at 5Hz for 5 to 10 minutes, depositing a film 0.5 to 1.0 $\mu$m thick. After ablation, the film is cooled to room temperature and the substrate removed from the vacuum chamber.

The film thus deposited is continuous and smooth over the entire substrate. In some locations there are particles on the film surface that appear to have been transported from the target either in solid particle form or as small melted globules. The film composition, measured by energy dispersive x-ray (EDX) spectroscopy, is found to be the same as the target composition for substrate temperatures up to 400°C. Thus if the target has the 2223 composition, the film has the same composition. When the substrate temperature is 600°C, the maximum content of the film is lower than that of the substrate because the film loses thallium by evaporation. The loss can be compensated by increasing the thallium content of the target.

The films are not superconducting as deposited, but become superconducting after annealing at 750-850°C in a gold pouch containing a source of thallium vapor.

An additional number of preparations were carried out using a variety of substrates. The substrates include polycrystalline forms of magnesium oxide, zirconia and alumina, as well as single crystal sapphire. The films are prepared by coating a chloroform solution of Tl, Ca, Ba and Cu 2-ethylhexanoates onto the substrate and pyrolyzing the film at 250°C. This process is repeated up to as many as 10 or more times to develop the desired thickness prior to high temperature processing. A film thickness of 5$\mu$ is obtained after coating a substrate three times.

The chemically deposited films are prepared by first coating cleaned substrates three times as described above. The prepyrolyzed film is amorphous by XRD and TEM. The film consists of an intimate mixture of the metal ions, where the Tl, Ca stoichiometry of the film prior to high temperature pyrolysis has not been found to be particularly critical to producing the high temperature superconductor (HTSC) material. However, if excess Ba and Cu are added, large hexagonal crystals of barium cuprate are produced during high temperature pyrolysis.

High temperature thermal processing is carried out using the following procedure. The initially amorphous chemically deposited film is placed between two source pellets. The source materials are typically 12.5 mm (1/2 inch) diameter uniaxially pressed powder compacts of Tl-Ca-Ba-Cu oxides. The stoichiometry of the source material plays a critical role in determining the phase(s) that are produced during processing. The two most common source compositions that are used are Tl-Ca-Ba-Cu ratios of 1313 and 2223. A spacer is placed between the pellets and a film inserted between them. The film surface is prevented from touching the surface of the pellet through the use of a ceramic or metal spacer. It is important to prevent contact of the film with the source material in order to obtain morphologically uniform films over large areas (>1cm$^2$). Contact of the film with the source material often destroys the uniformity and integrity of the final fired film.

The source/film structure is inserted into a preconditioned gold tube. The gold tube is then purged with air, nitrogen or oxygen, and closed (hermetic seal is not necessary). The material is then heated to a final temperature ranging between 600° and 910°C. The heating rate that is employed is important. Slow heating rates ranging from 10-30°C/min usually produce polycrystalline, unoriented films that range in thickness from 2-10 microns. Faster heating rates produce oriented films. The typical range of heating rates used to produce oriented films is between 50-500°C/min. The higher heating rates are obtained by placing the gold pouch directly into a preheated tube furnace and monitoring its temperature by using a thermocouple inserted directly into the pouch. The film orientation that is obtained upon rapid heating of chemically deposited films is largely the c-axis of the material normal to the substrate surface. Rocking curves as sharp as 0.3 degrees have been obtained for such materials. Some evidence for nucleation of material with its C-axis parallel to the substrate has also been observed; however this material represents a small volume fraction of any particular film. Epitaxy has been demonstrated for single crystal MgO substrates.

The degree of orientation of the film is intimately related to the phase formation process. The intermediate liquid phase that is obtained during high temperature processing plays a key role in controlling the morphology, phase identity and purity, crystallographic orientation and density of the film. The studies show that the intermediate liquid phase obtained consists primarily of Tl and Ca oxide at low temperature (ca., 600°C). Large grains of the 2-layer material have been observed at temperatures as low as 650°C for rapidly heated samples, indicating that liquid phase formation is indeed occurring at these relatively low temperatures. DSC experiments on pyrolyzed chemical precursors corroborate these findings. Slow heating rates (i.e., 10°C/min) result in a relatively small amount of liquid phase (per unit volume) being produced in the film and a large number of nucleation sites within the film. These factors combine to produce fine grained material (<5 microns) exhibiting a very low degree of crystallographic orientation. The nucleation is random in orientation and occurs throughout the deposit, resulting in a randomly interconnected platelet structure of the superconducting material. The coverage of the film on the substrate is excellent and uniform - apart from the fact that the film is a fairly porous network of 5 micron grains of material. A surface resistance measurement of a polycrystalline film on single crystal MgO revealed that the material had a reasonably low loss with a surface impedance that was approximately a factor of two greater than cryogenic copper at 50K and 10 GHz.

On the other hand, rapid heating rates (>50°C/min) produce a markedly different film morphology. During rapid heating of the precursor film, a large volume fraction of liquid phase is produced. The liquid, which initially consists primarily of Tl and Ca oxides, rapidly dissolves any barium and copper in contact with it and directly precipitates out the 2122 or 2223 compound. The liquid phase is very mobile and formed early in the heating process. Material transport via this intermediate liquid phase is extremely rapid. Thus an initially porous 5 micron (low initial density) thick film can shrink in thickness to just over 1 micron during processing. The phase that is produced from the liquid depends upon the overpressure that is in equilibrium with the liquid. The use of source materials that contain the 2223 phase (or produce it during the anneal experiment) will typically result in films that contain the 2223 phase. The local thallium overpressure is important to determining the phase that is produced from the liquid. If the overpressure is too low, no superconducting material is obtained.

The degree of crystallographic orientation of the film can be readily controlled through appropriate selection of the film process condition. By employing heating rates between 20 and 50°C/min (the end regimes for polycrystalline and oriented/epitaxial film growth), partially oriented films exhibiting a range of morphologies, densities, and thicknesses can be obtained.

Sharp superconducting transitions have been obtained for 2 layer films both by resistivity measurements (R=O at 107K) and AC susceptibility. An oriented 2122 film produced by this process on single crystal MgO has apparently the lowest surface resistance at 77K of any HTC film or bulk material that has been reported. This material was oriented and, perhaps, epitaxially related to the substrate. Films prepared using the same processing parameters were found to exhibit very sharp x-ray rocking curves; typically less than 0.7 degree full width at half maximum (FWHM). Values as low as 0.3 degrees were also obtained. This value is comparable to the best rocking curve data that have been reported for HTSC thin films of any material. Additionally, further improvement may be achieved with optimization of this process.

For rapid thermal annealing of films with a Tl overcoat, the following experiment was performed. A coating of Tl 2-ethylhexanoate was spun onto a prefixed film containing the oxides of Ca, Ba and Cu. The initial film was prepared by firing a normal stoichiometry film (2223) in a Tl overpressure insufficient to prevent complete vaporization of Tl from the sample. A total of three Tl overcoats were added followed by firing in an oxygen atmosphere at 860°C in a sealed gold pouch. A source pellet was included in the pouch to control the Tl overpressure. After processing, the film contained a large amount of 3-layer superconducting material.

In the next experiment, a 2223 mixture of the appropriate metal cations was dissolved in nitric acid and the solution evaporated onto a single crystal MgO substrate. This material was dried in a box furnace at 80°C and fired in a gold pouch using the normal procedure. The 2122 compound was formed from the thermally processed nitrate precursor. The morphology and composition of a number of areas of the film (SEM-EDX) were entirely consistent with the presence of the 2122 material. Other solutions or colloidal dispersions that may be used to deposit precursor films include carbonates, citrates, hydroxides, fluorides, chlorides, and acetates of these metal ions. Tl, Ca, Ba or Cu salts can share the same counterion (i.e., all be chloride salts), or consist of various complex mixtures of different anions. The precursors are fired under the appropriate conditions to complete phase formation and removal of the counterions (i.e., removal of halides requires heating under a water-containing atmosphere, oxygen atmosphere for organics).

Studies have conclusively shown that the intermediate liquid phase that was used to engineer the morphology and properties of the films can be very reactive with a number of different materials of technological interest. Direct physical contact of the partial melt produced within the film can result in degradation of the superconducting material; particularly on substrates such as sapphire or polycrystalline alumina. Often after processing the films on Al-containing substrates the presence of barium-aluminate crystallites in the film has been observed. The obvious corrosion of single crystal plates of the 2122 or 2223 compound that were produced early on during thermal processing but were subsequently dissolved by contact with liquid during processing to degrade the material were noted.

Superconducting Tl films on sapphire substrates are produced without interference from the substrate by employing the following technique. The first is to fire the film using an intermediate heating rate (approximately 50°C/min) that effectively serves to limit the amount of liquid phase that is present at any particular time during the process. The second is to limit the substrate reaction by reducing the amount of time the material is at high temperature. Both of these techniques have been demonstrated in the laboratory to be successful for controlling deleterious substrate reactions of the 2122 or 2223 phases on sapphire substrates.

Other than lowering the temperature or shortening the time at temperature, another method for reducing substrate reaction is to deposit a barrier layer onto the troublesome substrate material. MgO and Y-stabilized zirconia as buffer layer materials on sapphire, silicon and gallium arsenide substrates may be employed. Zirconia (yttria stabilized) and magnesium oxide demonstrated phase compatibility with these materials under the subject current process conditions. The buffer layer material can either be epitaxial or polycrystalline.

A number of preparations were carried out using the following experimental procedure.

The metal 2-ethylhexanoate precursor solutions were prepared using standard published synthetic procedures. The film itself was generated by spinning a solution prepared from copper 2-ethylhexanoate, barium 2-ethyl hexanoate, calcium 2-ethylhexanoate and thallium 2-ethylhexanoate onto the appropriate substrate. The film thickness was adjusted by controlling solution viscosity, spin speed, spin time and number of coats. Typically the substrate was spun at 3000 rpm for 30 sec. After each precursor coat, the film was fired at 250°C for 6 min to pyrolyse the 2-ethylhexanoate. This was repeated three times to build up sufficient thickness of the precursor material.

The pyrolysed films were loaded into gold pouches containing oxide pellets of known stoichiometry (for example Tl/1: Ca/3: Ba/1: Cu/3) and compression sealed. Both air and oxygen atmospheres have successfully produced the superconducting phase. The charged gold capsule was heated in a horizontal tube furnace at a temperature ranging from 750°C to 920°C and for times from 30 sec to 5 min and in all cases the superconducting phase was identified by powder X-ray diffraction and energy dispersive X-ray analysis.

A typical experimental procedure is outlined below:
5g copper 2-ethylhexanoate, 3.29g barium 2-ethylhexanoate, 3.14g calcium 2-ethylhexanoate and 8.462g thallium 2-ethylhexanoate in a minimum volume of chloroform were mixed by shaking for several hours. This precursor solution was spun onto a 1x1cm single crystal yttria-stabilized zirconia (>100< orientation) substrate at 3000 rpm for 30 sec followed by pyrolysis at 250°C for 6 min in a Lindberg box furnace. This spin/pyrolysis procedure was repeated twice more at 250°C. The coated substrate and oxide pellets with molar ratio Tl:Ca:Ba:Cu 1:3:1:3 were loaded into the gold pouch under air. The film was sandwiched between two pellets and the film surface kept from the pellet itself using a spacer made from thermocouple wire. This whole package was heated in a Lindberg 25 mm (1") tube furnace from 25°C to a temperature of 855°C in 10 min and held for 4 min. Cooling to room temperature took a further 5 min and was achieved by opening the furnace.

Advantages of the laser ablation method include the cleanliness inherent in vacuum deposition, precise and repeatable control of the rate of film growth, control of film stoichiometry via the target composition, control of oxygen activity via the choice of oxygen species and/or plasma activation, and the ability to grow on a substrate at elevated temperature to encourage epitaxial growth.

The subject articles comprising superconductive thallium-based layers on crystalline substrates provide for an extraordinary advance over previously prepared materials. The subject articles have superconductive properties at liquid nitrogen or higher temperatures, are highly oriented and are grown epitaxially on a crystalline substrate and as shown, provide for a number of highly desirable physical and electrical properties.

With the methods described for producing the subject compositions, growth can be carefully controlled, so as to provide for highly oriented and epitaxial films. In addition, the thickness can be controlled, so as to provide for greater homogeneity and uniformity of the sol-gel film. Also, the rate of growth of the crystallites is controlled under controlled temperature conditions, to provide for substantial homogeneity.

Advantages of the sol-gel technique include the capability to coat large areas uniformly, atomic-scale mixing of the components at room temperature, low temperature synthesis of mixed metal oxides, amenability to powder, bulk, film or fiber development, as well as attaining of high chemical purities.

The laser ablation system has the advantages of safety, the system is opened at room temperature, the opportunity to prepare the superconducting Tl films in situ, and the ablation and condensation zone may be surrounded by disposable shields, where stray thallium will deposit, rate of growth and thickness can be carefully controlled, and epitaxial growth can be encouraged.

The methods described for producing films of varying thicknesses having superconductive properties are convenient, allow for coating of a variety of substrates, and can provide different physical characteristics of the superconductive film.

Although the foregoing invention has been described in some detail by way of illustration and example for purposes of clarity of understanding, it will be readily apparent to those of ordinary skill in the art in light of the teachings of this invention that certain changes and modifications may be made thereto without departing from the scope of the appended claims.

**Claims**

1. A superconducting article comprising an oriented, epitaxial superconducting layer of thallium, optionally calcium, barium, and copper oxide on a crystalline substrate, said layer being at least $30 \cdot 10^{-10}$ m thick, and having a c-axis oriented normal to the crystalline substrate surface and being epitaxial to the substrate.

2. A superconducting article according to Claim 1, wherein said superconducting layer has the 2122 composition.

3. A superconducting article according to Claim 1, wherein said superconducting layer has the 2223 composition.

4. A superconducting article according to Claim 1, wherein said substrate is magnesium oxide or yttria stabilized zirconia.

5. A superconducting article comprising a superconducting epitaxial layer of thallium, barium, calcium and copper oxide on magnesium oxide said magnesium oxide being a substrate, wherein the layer is epitaxial to the substrate.

6. A superconducting article according to Claim 5, wherein said superconducting layer is the 2122 composition.

7. A microwave or millimeter device comprising an article according to any of Claims 1, 5 and 6, wherein said superconducting layer is under 1 micrometer in thickness.

8. The superconducting article of Claim 1 wherein the layer thickness is less than or equal to 2 microns.

9. The superconducting article of Claim 1 wherein the crystalline substrate consists of a single crystal.

10. The superconducting article of Claim 1 wherein the substrate is lanthanum aluminate or sapphire.

11. The superconducting article of Claim 1 wherein the epitaxial superconducting layer measures at least 3 centimeters as the smallest dimension in the a and b axes of the layer.

12. The superconducting article of Claim 1 wherein the epitaxial superconducting layer measures at least 5 centimeters as the smallest dimension in the a and b axes of the layer.

13. The microwave or millimeter device of Claim 7 wherein the device includes a resonator.

14. The microwave or millimeter device of Claim 7 wherein the device includes a delay line.

15. The superconducting article of Claim 1 wherein the surface resistance is less than $10^{-3}$ ohms at 10 GHz at about 77K.

16. The superconducting article of Claim 15 wherein the surface resistance is less than $10^{-4}$ ohms at 10 GHz at about 77K.

17. The superconducting article of Claim 1 wherein the epitaxial superconducting layer measures at least 0.5 centimeters as the smallest dimension in the a and b axes of the layer.

**Patentansprüche**

1. Supraleitender Gegenstand (Formkörper), der umfaßt eine gerichtete (orientierte) supraleitende Epitaxieschicht aus Thallium, gegebenenfalls Calcium, Barium und Kupferoxid auf einem kristallinen Substrat, wobei diese Schicht mindestens 30 x $10^{-10}$ m dick ist und eine c-Achse aufweist, die senkrecht zur kristallinen Substratoberfläche ausgerichtet und epitaxial zu dem Substrat ist.

2. Supraleitender Gegenstand nach Anspruch 1, worin die supraleitende Schicht die Zusammensetzung 2122 hat.

3. Supraleitender Gegenstand nach Anspruch 1, worin die supraleitende Schicht die Zusammensetzung 2223 hat.

4. Supraleitender Gegenstand nach Anspruch 1, worin das Substrat Magnesiumoxid oder Yttriumoxid ist, das mit Zirkoniumdioxid stabilisiert ist.

5. Supraleitender Gegenstand, der umfaßt eine supraleitende Epitaxieschicht aus Thallium, Barium, Calcium und Kupferoxid auf Magnesiumoxid, wobei das Magnesiumoxid das Substrat ist, wobei die Schicht epitaxial zu dem Substrat ist.

6. Supraleitender Gegenstand nach Anspruch 5, worin die supraleitende Schicht die Zusammensetzung 2122 hat.

7. Mikrowellen- oder Millimeter-Vorrichtung, die umfaßt einen Gegenstand nach einem der Ansprüche 1, 5 und 6, wobei die supraleitende Schicht eine Dicke von weniger als 1 μm hat.

8. Supraleitender Gegenstand nach Anspruch 1, worin die Schichtdicke ≤ 2 μm beträgt.

9. Supraleitender Gegenstand nach Anspruch 1, worin das kristalline Substrat aus einem Einkristall besteht.

**10.** Supraleitender Gegenstand nach Anspruch 1, worin das Substrat Lanthanaluminat oder Saphir ist.

**11.** Supraleitender Gegenstand nach Anspruch 1, worin die supraleitende Epitaxieschicht Abmessungen von mindestens 3 cm als kleinste Dimension in den a- und b-Achsen der Schicht hat.

**12.** Supraleitender Gegenstand nach Anspruch 1, worin die supraleitende Epitaxieschicht Abmessungen von mindestens 5 cm als kleinste Dimension in den a- und b-Achsen der Schicht hat.

**13.** Mikrowellen- oder Millimeter-Vorrichtung nach Anspruch 7, die einen Resonator umfaßt.

**14.** Mikrowellen- oder Millimeter-Vorrichtung nach Anspruch 7, die eine Verzögerungsleitung umfaßt.

**15.** Supraleitender Gegenstand nach Anspruch 1, worin der Oberflächenwiderstand weniger als $10^{-3}$ Ohm bei 10 GHz bei etwa 77°K beträgt.

**16.** Supraleitender Gegenstand nach Anspruch 15, worin der Oberflächenwiderstand weniger als $10^{-4}$ Ohm bei 10 GHz bei etwa 77°K beträgt.

**17.** Supraleitender Gegenstand nach Anspruch 1, worin die supraleitende Epitaxieschicht Abmessungen von mindestens 0,5 cm als kleinste Dimension in den a- und b-Achsen der Schicht hat.


**Revendications**

**1.** Article supraconducteur comprenant une couche supraconductrice épitaxiale orientée de thallium, éventuellement de calcium, de baryum et d'oxyde de cuivre sur un substrat cristallin, ladite couche ayant une épaisseur d'au moins $30.10^{-10}$ m, ayant un axe c orienté normalement à la surface de substrat cristallin et étant épitaxiale par rapport au substrat.

**2.** Article supraconducteur selon la revendication 1, dans lequel ladite couche supraconductrice est de composition 2122.

**3.** Article supraconducteur selon la revendication 1, dans lequel ladite couche supraconductrice est de composition 2223.

**4.** Article supraconducteur selon la revendication 1, dans lequel ledit substrat est en oxyde de magnésium ou en zircone stabilisée à l'yttrium.

**5.** Article supraconducteur comprenant une couche épitaxiale supraconductrice de thallium, de baryum, de calcium et d'oxyde de cuivre sur de l'oxyde de magnésium, ledit oxyde de magnésium étant un substrat, dans lequel la couche est épitaxiale par rapport au substrat.

**6.** Article supraconducteur selon la revendication 5, dans lequel ladite couche supraconductrice est de composition 2122.

**7.** Dispositif à micro-ondes ou à ondes millimétriques, comprenant un article conforme à l'une quelconque des revendications 1, 5 et 6, dans lequel ladite couche supraconductrice a une épaisseur inférieure à 1 micromètre.

**8.** Article supraconducteur selon la revendication 1, dans lequel l'épaisseur de la couche est inférieure ou égale à 2 micromètres.

**9.** Article supraconducteur selon la revendication 1, dans lequel le substrat cristallin est constitué d'un monocristal.

**10.** Article supraconducteur selon la revendication 1, dans lequel le substrat est un aluminate de lanthane ou un saphir.

**11.** Article supraconducteur selon la revendication 1, dans lequel la dimension la plus petite de la couche supraconductrice épitaxiale, sur les axes a et b de la couche, est d'au moins 3 centimètres.

**12.** Article supraconducteur selon la revendication 1, dans lequel la dimension la plus petite de la couche supraconductrice épitaxiale, sur les axes a et b de la couche, est d'au moins 5 centimètres.

**13.** Dispositif à micro-ondes ou à ondes millimétriques selon la revendication 7, dans lequel le dispositif comprend un résonateur.

**14.** Dispositif à micro-ondes ou à ondes millimétriques selon la revendication 7, dans lequel le dispositif comprend une ligne à retard.

**15.** Article supraconducteur selon la revendication 1, dans lequel la résistance superficielle est inférieure à $10^{-3}$ ohm à 10 GHz à environ 77 K.

**16.** Article supraconducteur selon la revendication 17, dans lequel la résistance superficielle est inférieure à $10^{-4}$ ohm à 10 GHz à environ 77 K.

**17.** Article supraconducteur selon la revendication 1, dans lequel la dimension la plus petite de la couche supraconductrice épitaxiale, sur les axes a et b de la couche, est d'au moins 0,5 centimètre.

FIG. 1

FIG. 2

FIG. 3

FIG. 4

ANTENNA

MICROWAVE RECIEVER

100

102

MICROWAVE FILTER

MIXER

104

112

DISPERSIVE DELAY LINE

106

114

110

SWEPT LOCAL OSCILLATOR

OUTPUTS AMPLI-
TUDE VERSUS
FREQUENCY VERSUS
TIME SIGNAL SPEC-
TRUM AT NYQUIST
DATA RATE.

W

W

118

W

116

S

α      α      α      α

→ SMA  COAXIAL CONNECTORS

FIG. 5

ANTENNA

DIGITAL INSTANTANEOUS FREQUENCY
MEASUREMENT (DIFM)

120

122

130

136   HI

POWER SPLITTER

PHASE DETECTOR

140   VII

124   132   DELAY LINE

T

134   136

V₁₀c

DELAY LINE

134

FIG. 6